# FASCICULE DE BREVET EUROPEEN

(11) **EP 0 732 782 B1**
(45) Date de publication et mention de la délivrance du brevet: **23.09.1998**
(21) Numéro de dépôt: 96400501.1
(22) Date de dépôt: 11.03.1996
(51) Int. Cl.: H01S 3/025, H04B 10/12, H01L 27/15

(54) **Dispositif photonique duplexeur**
Optischer Duplexer
Optical duplexer

(30) Priorité: 16.03.1995 FR 9503057
(43) Date de publication de la demande: 18.09.1996
(73) Titulaire: ALCATEL ALSTHOM Compagnie Générale d'Electricité, 75008 Paris (FR)
(72) Inventeur: Goldstein, Leon, 92370 Chaville (FR); Gentner, Jean Louis, 91190 Gif sur Yvette (FR); Brillouet, François, 92310 Sevres (FR)
(74) Mandataire: Prugneau, Philippe

(56) Documents cités:
- GB-A- 2 243 720
- US-A- 5 031 188
- PROCEEDINGS OF THE EUROPEAN CONFERENCE ON OPTICAL COMMUNICATION (EC, MONTREUX, SEPT. 12 - 16, 1993 REGULAR PAPERS, vol. 2, 12 Septembre 1993, SWISS ELECTROTECHNICAL ASSOCIATION, pages 325-328, XP000492232 GIBBON M ET AL: "HIGH-SPEED ELECTROABSORPTION MODULATOR MONOLITHICALLY INTEGRATED WITH A 2X /8 DFB LASER AND BACK MONITOR BY SELECTIVE AREA MOVPE"
- APPLIED PHYSICS LETTERS, vol. 63, no. 7, 16 Août 1993, NEW YORK US, pages 880-882, XP000388128 Z.M. CHUANG ET AL: "Photonic integrated tunable receivers with optical preamplifiers for direct detection"

## Description

L'invention concerne un dispositif semiconducteur photonique et, plus particulièrement, un dispositif duplexeur employé comme émetteur et récepteur dans un système de communication par signaux optiques.

L'invention s'applique notamment aux équipements d'émission/réception sur fibre optique chez l'abonné.

Le multiplexage en longueur d'onde (connu aussi sous le terme WDM pour "Wavelength-Division-Multiplexing") permet d'établir des communications bidirectionnelles simultanées sur une seule fibre optique d'un système de communication par signaux optiques ou encore d'établir des communications multicanaux sur une seule fibre optique.

Dans le cas d'une communication bidirectionnelle sur une seule fibre optique, il s'agit de recevoir un premier signal optique à une certaine longueur d'onde et d'émettre un second signal optique à une autre longueur d'onde au sein d'un dispositif semiconducteur intégré.

Il a déjà été envisagé de mettre au point un dispositif semiconducteur intégrant les différentes fonctions optiques sur un même substrat pour la transmission d'un premier signal optique à une certaine longueur d'onde, par exemple à 1,3 µm, et la réception d'un second signal optique à une autre longueur d'onde, par exemple à 1,55 µm.

On a d'abord pensé à une optique guidée sur un substrat InP (Phosphore d'Indium) incluant une fonction de séparation des signaux optiques de longueurs d'onde différentes par démultiplexage sur deux voies distinctes, par exemple à l'aide d'un coupleur sélectif ou d'un interféromètre.

Toutefois, cette solution s'avère en pratique complètement inadaptée pour l'application aux équipements grand public d'émission/réception sur fibre optique chez l'abonné car elle est d'une mise en oeuvre complexe et coûteuse. Par ailleurs, il s'avère extrêmement difficile d'assurer l'indépendance du démultiplexeur vis-à-vis de la polarisation de la lumière véhiculée dans le composant.

Le dispositif semiconducteur duplexeur, connu des documents GB 2 243 720, US 5 031 188 et US 5 144 637, résout les problèmes indiqués ci-dessus.

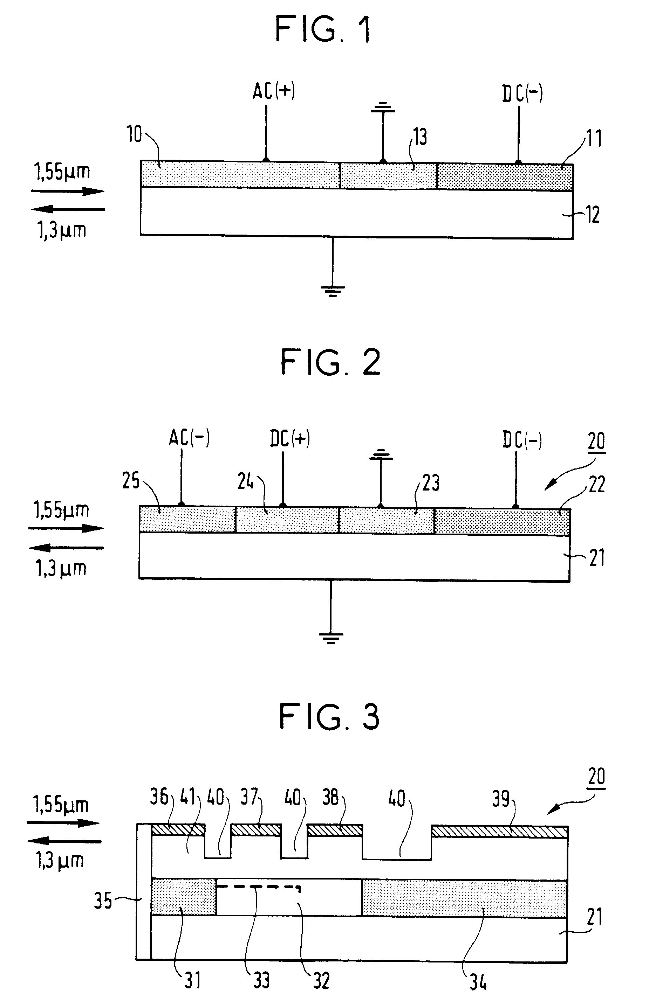

Ce dispositif, montré très schématiquement sur la figure 1, comprend un laser 10 qui génère le premier signal optique à une première longueur d'onde (ici 1,3 µm) et un photodétecteur 11 qui détecte un second signal optique à une seconde longueur d'onde (ici 1,55 µm). Le laser 10 et le photodétecteur 11 sont intégrés sur une même structure de guide d'onde optique 12 avec un absorbeur 13 sélectif à la longueur d'onde du premier signal (ici 1,3 µm) et disposé entre le laser et le photodétecteur de façon colinéaire suivant un axe longitudinal de la structure de guide d'onde optique 12.

L'absorbeur sélectif 13 sert à isoler la fonction d'émission et la fonction de réception en empêchant le signal optique à la première longueur d'onde de se propager vers le photodétecteur. En effet, le premier signal optique généré par le laser 10 à tendance à se propager suivant l'axe longitudinal de la structure du guide d'onde, dans les deux directions indiquées par les flèches sur la figure 1.

Dans ce dispositif semiconducteur duplexeur connu, le laser 10 est excité par un potentiel alternatif AC(+) de façon à moduler le premier signal optique en fonction de données numériques à transmettre.

A l'inverse, le photodétecteur 11 est polarisé négativement. Lorsqu'il est excité par le second signal optique modulé, on récupère un courant alternatif représentatif de données numériques codées dans ce second signal.

L'intégration optique des trois fonctions réalisées par le laser modulateur, le photodétecteur et l'absorbeur est relativement simple à réaliser, notamment à l'aide de techniques de croissance de structures hétérogènes de matériaux semiconducteurs conventionnels. La structure finale obtenue reste peu dépendante de la polarisation de la lumière véhiculée dans le guide d'onde optique.

Toutefois, l'absorbeur 13 n'étant pas un isolateur parfait, il laisse néanmoins passer vers le photodétecteur une partie du premier signal optique généré par le laser 10. Du fait que le premier signal optique est modulé par les données numériques, il parasite le second signal optique de telle façon qu'il est extrêmement difficile de le filtrer au sein de la fonction de réception. Il en résulte donc des phénomènes de diaphonie optique entre le laser et le photodétecteur qui nuisent aux performances du dispositif duplexeur, en particulier qui nuisent à la sensibilité du photodétecteur.

En plus, on constate des phénomènes de diaphonie électrique entre le laser et le photodétecteur du fait qu'ils sont proches l'un de l'autre et qu'ils sont excités par des sources électriques alternatives.

Un but de l'invention est de proposer un dispositif semiconducteur duplexeur qui ne présente pas les inconvénients indiqués ci-dessus.

Un autre but de l'invention est de proposer un tel dispositif semiconducteur duplexeur qui soit simple à réaliser, peu coûteux, et ayant des performances, notamment en ce qui concerne le rapport S/B de la fonction réception, adaptées à l'application grand public des équipements d'émission/réception sur fibre optique chez l'abonné.

A cet effet, l'invention a pour objet un dispositif semiconducteur duplexeur comprenant un moyen pour générer un premier signal optique ayant une certaine longueur d'onde, un moyen pour détecter un second signal optique ayant une autre longueur d'onde, le moyen générateur et le moyen détecteur faisant partie intégrante d'un guide d'onde optique apte à propager lesdits premier et second signaux optiques et étant disposés colinéairement suivant un axe longitudinal dudit guide d'onde optique. Le moyen générateur fonctionne pour générer le premier signal optique sous la forme d'une onde continue. Il est en outre disposé colinéairement suivant ledit axe longitudinal entre le moyen détecteur et un moyen pour moduler sélectivement ledit premier signal optique et qui fait partie intégrante dudit guide d'onde optique.

Ainsi, contrairement au dispositif connu notamment du document GB 2 243 720, la modulation du premier signal optique est réalisée à l'extérieur du moyen générateur de sorte que la partie du premier signal optique non modulé qui est reçue par le moyen détecteur peut facilement être filtrée pour être séparée du second signal optique afin d'éviter les problèmes de diaphonie optique entre les fonctions d'émission et de réception.

La partie du premier signal optique qui arrive sur le moyen détecteur peut être considérablement réduite si un absorbeur sélectif à la longueur d'onde du premier signal optique est prévu entre le moyen générateur et le moyen détecteur.

Puisque le moyen générateur doit produire un signal optique continu, il peut être excité par un potentiel électrique constant, comme l'absorbeur et le moyen détecteur, ce qui permet de réduire les fuites électriques entre la fonction d'émission et la fonction de réception.

Les caractéristiques du dispositif selon l'invention contribuent à l'obtention d'une structure intégrée dans une géométrie colinéaire suivant l'axe longitudinal du guide d'onde optique et indépendante de la polarisation de la lumière qui traverse cette structure.

Avantageusement le moyen générateur selon l'invention inclut un laser du type à réseau distribué, à réflecteur de Bragg distribué ou encore de Fabry-Perot, facile à implanter sur une structure en matériaux semiconducteurs.

En outre la combinaison d'un laser émettant en continu et d'un modulateur externe au laser permet d'obtenir une lumière modulée (premier signal optique) fortement unidirectionnelle, c'est-à-dire une lumière qui ne se propage pas dans le guide d'onde optique en direction du détecteur. Ainsi, on peut obtenir un dispositif semiconducteur duplexeur dont la fonction de réception présente la sensibilité requise pour une application grand public.

D'autres caractéristiques et avantages apparaîtront encore à la lecture de la description qui suit d'un exemple de réalisation du dispositif semiconducteur duplexeur selon l'invention.

La figure 1 montre schématiquement un dispositif semiconducteur duplexeur de l'état antérieur de la technique.

La figure 2 montre schématiquement le dispositif semiconducteur duplexeur selon l'invention.

La figure 3 montre plus en détail les composants du dispositif montré sur la figure 2.

Selon l'invention, le duplexeur est réalisé sous la forme d'un composant monolithique photonique intégré. En particulier, le générateur de signaux optiques et le détecteur de signaux optiques sont intégrés individuellement dans une géométrie colinéaire avec une couche d'un matériau semi-conducteur servant de guide d'onde optique linéaire.

Le duplexeur selon l'invention présente une longueur suivant un axe longitudinal du guide d'onde d'environ 800 à 1000 µm.

Ce guide d'onde optique est apte à propager dans un sens suivant l'axe longitudinal du guide d'onde des signaux optiques à une première longueur d'onde et dans l'autre sens des signaux optiques à une seconde longueur d'onde différente de la première longueur d'onde. Dans le cas présent, le générateur émet des signaux optiques ayant une longueur d'onde de 1,3 µm et le détecteur reçoit des signaux optiques ayant une longueur d'onde de 1,55 µm.

Figure 2, le dispositif semi-conducteur duplexeur 20 est montré très schématiquement. Il inclut successivement suivant l'axe longitudinal du guide d'onde optique indiqué par 21, un photo détecteur 22 sensible à des signaux optiques à une première longueur d'onde (ici 1,55 µm), un absorbeur 23 sélectif pour des signaux optiques à une seconde longueur d'onde (ici 1,3 µm), un générateur 24 de signaux optiques à la seconde longueur d'onde et un modulateur 25 sélectif pour des signaux optiques à la seconde longueur d'onde.

Suivant l'invention, le générateur 24 inclut un laser à réseau distribué (DFB) ou un laser réflecteur de Bragg distribué ou encore un laser de Fabry-Perot.

Le générateur présente la particularité d'émettre des signaux optiques sous forme d'une onde continue, c'est-à-dire des signaux non modulés, ces signaux constituant une porteuse pour le modulateur sélectif 25 qui peut facilement être séparée des signaux optiques qui doivent être détectés par le photo détecteur 22.

Selon l'invention, le générateur à laser 24 est excité par un potentiel constant DC(+), comme l'absorbeur sélectif 23 (qui est dans le cas présent relié à la masse) et le photodétecteur (polarisé négativement par le signal DC(-)), ce qui contribue à réduire les fuites électriques entre la fonction d'émission et la fonction de détection d'autant plus que les deux éléments qui peuvent interférés optiquement et électriquement, sont les éléments qui sont le plus éloignés l'un de l'autre suivant l'axe longitudinal du guide d'onde.

Ainsi, comme visible sur la figure 2, le modulateur 25, qui est situé à une extrémité du guide d'onde, est soumis à une tension inverse alternative AC(-) pour moduler le signal optique à la seconde longueur d'onde tandis que le photo détecteur 22, qui est situé à l'autre extrémité du guide d'onde, fournit un courant modulé par le signal reçu à la première longueur d'onde sous une polarisation inverse constante DC(-).

A noter que le modulateur 25 et le photo détecteur 22 selon l'invention fonctionnent pour des débits d'environ 600 Mb/s dans les sens d'émission et de réception.

Figure 3, les éléments du composant monolithique constituant le duplexeur 20 selon l'invention sont montrés plus en détail.

La partie active du guide d'onde optique 21 comprend successivement une zone 31 électro-absorbante à 1,25 µm pour la modulation du signal optique à la longueur d'onde de 1,3 µm qui sort du duplexeur, cette zone 31 étant transparente pour le signal optique à la longueur d'onde de 1,55 µm qui entre dans le duplexeur. La zone 31 est suivie d'une zone 32 de composition quaternaire (InGaAsP), par exemple, à 1,3 µm qui fait partie du laser DFB dont le réseau distribué 33 est illustré en traits interrompus. La zone 32 est suivie d'une zone 34 de composition quaternaire à 1,25 µm faisant partie du détecteur.

La face avant du duplexeur 20 est munie d'une couche diélectrique 35 formant une couche antireflet.

Les électrodes du modulateur, du générateur de l'absorbeur et du détecteur sont indiquées respectivement par 36,37,38,39 et sont isolées électriquement les unes des autres en 40 par des gravures dans un ruban 41 déposé sur le guide d'onde 21. En plus, une couche absorbante de composition ternaire à 1,65 µm est déposée entre l'électrode 39 et la zone 34 de sorte à faire fonctionner cette région comme un photo détecteur à la longueur d'onde de 1,55 µm.

La zone active du guide d'onde 21 est déposée sur un substrat InP muni d'une électrode (non représentée) reliée à la masse.

Le composant duplexeur 20 selon l'invention est destiné à faire partie d'équipements installés chez l'abonné et connectés par fibre optique à une station d'émission/réception d'un système de communication par signaux optiques.

## Revendications

1. Un dispositif semi-conducteur duplexeur comprenant un moyen (24) pour générer un premier signal optique ayant une certaine longueur d'onde, un moyen (22) pour détecter un second signal optique ayant une autre longueur d'onde, le moyen générateur et le moyen détecteur faisant partie intégrante d'un guide d'onde optique (21) apte à propager lesdits premier et second signaux optiques et étant disposés colinéairement suivant un axe longitudinal dudit guide d'onde optique, caractérisé en ce que le moyen générateur fonctionne pour générer le premier signal optique sous la forme d'une onde continue et en ce qu'il est disposé, colinéairement suivant ledit axe longitudinal, entre le moyen détecteur et un moyen (25) pour moduler sélectivement ledit premier signal optique et qui fait partie intégrante dudit guide d'onde optique.

2. Le dispositif selon la revendication 1, comprenant en outre un moyen (23) pour absorber une partie dudit premier signal optique qui est propagée vers le moyen détecteur, ce moyen absorbeur étant disposé colinéairement suivant ledit axe longitudinal entre le moyen générateur et le moyen détecteur.

3. Le dispositif selon la revendication 2, dans lequel le moyen générateur (24) et le moyen absorbeur (23) sont excités par un potentiel constant.

4. Le dispositif selon la revendication 3, dans lequel le moyen générateur (24) inclut un laser à réseau distribué.

5. Le dispositif selon la revendication 3, dans lequel le moyen générateur (24) inclut un laser à réflecteur de Bragg distribué.

6. Le dispositif selon la revendication 3, dans lequel le moyen générateur (24) inclut un laser de Fabry-Perot.

7. Le dispositif selon la revendication 3, dans lequel ladite certaine longueur d'onde est égale à 1,3 µm et l'autre longueur d'onde est égale à 1,55 µm.

## Patentansprüche

1. Duplex-Halbleitervorrichtung mit einem Erzeugungsmittel (24) zum Erzeugen eines ersten optischen Signals mit einer bestimmten Wellenlänge, einem Erfassungsmittel (22) zum Erfassen eines zweiten optischen Signals mit einer anderen Wellenlänge, wobei das Erzeugungsmittel und das Erfassungsmittel integrierender bestandteil eines optischen Wellenleiters (21) sind, der geeignet ist, das erste und das zweite optische Signal zu übertragen, und kollinear entlang einer Längsachse des optischen Wellenleiters angeordnet sind,
dadurch gekennzeichnet, daß das Erzeugungsmittel funktioniert, um das erste optische Signal in der Form einer kontinuierlichen Welle zu erzeugen, und daß es kollinear entlang der Längsachse zwischen dem Erfassungsmittel und einem Mittel (25) zum selektiven Modulieren des ersten optischen Signals angeordnet ist, das integrierender Bestandteil des optischen Wellenleiters ist.

2. Vorrichtung nach Anspruch 1, ferner mit einem Absorptionsmittel (23) zum Absorbieren eines Teils des ersten optischen Signals, das in Richtung des Erfassungsmittels übertragen wird, wobei dieses Absorptionsmittel kollinear entlang der Längsachse zwischen dem Erzeugungsmittel und dem Erfassungsmittel angeordnet ist.

3. Vorrichtung nach Anspruch 2, bei der das Erzeugungsmittel (24) und das Absorbtionsmittel (23) durch ein konstantes Potential geregelt werden.

4. Vorrichtung nach Anspruch 3, bei der das Erzeugungsmittel (24) einen Laser mit verteiltem Gitter umfaßt.

5. Vorrichtung nach Anspruch 3, bei der das Erzeugungsmittel (24) einen Laser mit verteiltem Bragg-Reflektor umfaßt.

6. Vorrichtung nach Anspruch 3, bei der das Erzeugungsmittel (24) einen Fabry-Perot-Laser umfaßt.

7. Vorrichtung nach Anspruch 3, bei der die bestimmte Wellenlänge gleich 1,3 µm und die andere Wellenlänge gleich 1,55 µm ist.

## Claims

1. Semiconductor diplex transceiver comprising means (24) for generating a first optical signal having a certain wavelength, means (22) for detecting a second optical signal having another wavelength, the generator means and the detector means forming integral parts of an optical waveguide (21) adapted to propagate said first and second optical signals and being disposed in an inline configuration along a longitudinal axis of said optical waveguide, characterised in that the generator means generate the first optical signal in the form of a continuous wave and in that they are disposed in an inline configuration along said longitudinal axis between the detector means and means (25) for selectively modulating said first optical signal forming an integral part of said optical waveguide.

2. Device according to claim 1 further comprising means (23) for absorbing a part of said first optical signal that is propagated towards the detector means, said absorber means being disposed in an inline configuration along said longitudinal axis between the generator means and the detector means.

3. Device according to claim 2 wherein the generator means (24) and the absorber means (23) are excited by a constant potential.

4. Device according to claim 3 wherein the generator means (24) include a DFB laser.

5. Device according to claim 3 wherein the generator means (24) include a distributed Bragg reflector laser.

6. Device according to claim 3 wherein the generator means (24) include a Fabry-Perot laser.

7. Device according to claim 3 wherein said certain wavelength is 1.3 µm and the other wavelength is 1.55 µm.
